Europäisches Patentamt

European Patent Office

Office européen des brevets

(11) Veröffentlichungsnummer: **0 156 016 B1**

# EUROPÄISCHE PATENTSCHRIFT

(45) Veröffentlichungstag der Patentschrift: **13.03.91**

(21) Anmeldenummer: **84115286.1**

(22) Anmeldetag: **12.12.84**

(51) Int. Cl.⁵: **G11C 11/00, H01F 3/10, G01P 3/487, H01F 3/06**

(54) Spulenkern für eine induktive, frequenzunabhängige Schaltvorrichtung.

(30) Priorität: **26.03.84 DE 3411079**

(43) Veröffentlichungstag der Anmeldung: **02.10.85 Patentblatt 85/40**

(45) Bekanntmachung des Hinweises auf die Patenterteilung: **13.03.91 Patentblatt 91/11**

(84) Benannte Vertragsstaaten: **DE FR GB IT NL SE**

(56) Entgegenhaltungen:
**EP-A- 0 085 140**
**DE-C- 3 152 008**
**US-A- 3 820 090**
**US-A- 3 892 118**

(73) Patentinhaber: **VACUUMSCHMELZE GMBH Grüner Weg 37 Postfach 2253 W-6450 Hanau 1(DE)**

(72) Erfinder: **Rauscher, Gerd Schillerstrasse 8 W-6451 Gross-Krotzenburg(DE)**
Erfinder: **Radeloff, Christian, Dr. Fritz-Schubert-Ring 36 W-6454 Bruchröbel 1(DE)**

**Beschreibung**

Die Erfindung betrifft einen Spulenkern für eine induktive, frequenzunabhängige Schaltvorrichtung, der einen draht- oder frequenzunabhängige Schaltvorrichtung, der einen draht- oder stabförmigen Verbundkörpen aufweist, mindestens zwei gegeneinander in Richtung der Längsachse des Verbundkörpers mechanisch verspannten Materialien besteht, von denen mindestens eines ferromagnetisch ist und in Richtung der Längsachse anisotrope, weichmagnetische Eigenschaften besitzt.

Ein derartiger dreh- oder stabförmiger Verbundkörper mit einer anisotropen „weichmagnetischen Schicht ist beispielsweise aus der DE-C- 31 52 008 bekannt. Der Verbundkörper besteht beispielsweise aus einem Nickelkern mit einem Magneten aus einer Kobalt-Vanadium-Chrom-Legierung. Kern und Mantel sind dabei z.B. durch Ziehen oder durch eine Wärmebehandluug in Verbindung mit Materialien unterschiedlicher thermischer Ausdehnung mechanisch gegeneinander verspannt, so daß in Richtung der Längsachse des Verbundkörpers auf das weichmagnetische Material im Kern oder im Mantel eine Zug- bzw. eine Druckspannung ausgeübt wird. Bei einer Ummagnetisierung eines derartigen Verbundkörpers erhält man Polarisationssprünge, die besonders bei unsymmetrischem Durchlaufen der Hystereseschleife auftreten (Spalte 8, Zeilen 5 bis 10).

Die dort beschriebenen Polarisationssprünge stellen eine schnelle Ummagnetisierung in einer magnetischen Vorzugsrichtung dar, wie sie bereits von Franz Preisach in der Physikalischen Zeitschrift XXXIII aus dem Jahre 1932, Seiten 913 bis 923 beschrieben wurde. Hier wurde gezeigt, daß bei langen, unter Zugspannung stehenden Drähten die Ummagnetisiernng des Drahtes praktisch in einem einzigen großen Barkhausensprnng erfolgen kann, so daß sich eine von der Geschwindigkeit der Feldänderung unabhängige Ummagnetisierung ergibt und damit in einer Spule ein frequenzunabhängiger Spannungsimpuls induziert wird.

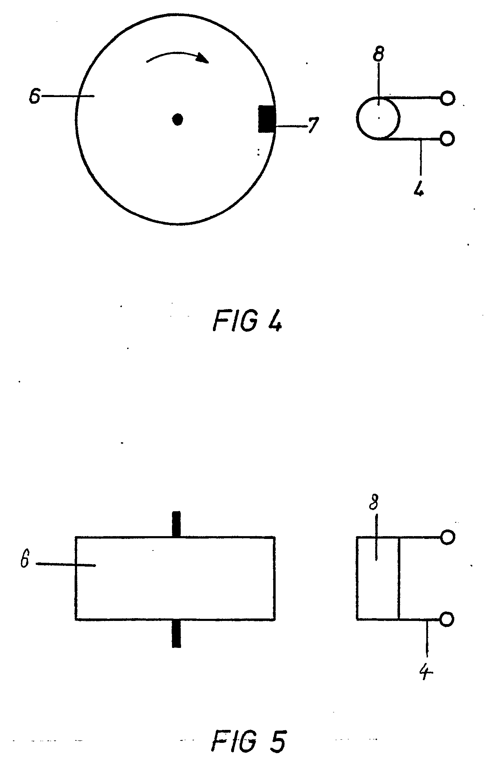

Weiterhin ist es aus der europäischen Patentanmeldung Nr. 0 085 140, insbesondere aus Figur 4 und Seite 8, bekannt, daß bei einer asymmetrischen Magnetfeldanregung ein magnetischer Draht, bestehend aus einem hartmagnetischen Kern und einer weichmagnetischen, tordierten und magnetostriktiven Schicht, die den hartmagnetischen Kern umgibt, eine plötzliche Ummagnetisierung der weichmagnetischen Schicht erzielt werden kann. Der durch diese Ummagnetisierung in einer den magnetischen Dreht umgebenden Spule induzierte Impuls hängt in Spannungshöhe und Zeitdauer nur unwesentlich von der Geschwindigkeit der äußeren Feldstärkeänderung ab.

Bei allen diesen bekannten Einrichtungen müssen die verwendeten Materialien gut verformbar sein; bestimmte Wärmeausdehnungskoeffizienten zueinander aufweisen und sich leicht walzen bzw. ziehen lassen. Außerdem muß man mindestens bei den Schaltdrähten, die keine hartmagnetischen Komponenten haben, sehr lange Drähte verwenden, um freguenzunabhängig induzierte Impulse zu erreichen.

Aufgabe der vorliegenden Erfindung ist es demgegenüber, einen Spulenkern zu schaffen, der keine besonders große Länge aufweisen muß und der unabhängig von der Größe und Änderungsgeschwindigkeit des einwirkenden äußeren Magnetfeldes bei Durchlaufen einer ganz bestimmten Feldstärke in einer Richtung einen frequenzunabhängigen Impuls in einer den Spulenkern umgebenden Spule erzeugt.

Diese Aufgabe wird erfindungsgemäß dadurch gelöst, daß parallel zur und/oder in Richtung der Längsachse des Verbundkörpers an diesem mindestens ein in Richtung dieser Längsachse magnetisierter Dauermagnet befestigt ist. Vorteilhafte Weiterbildungen dieser Einrichtung sind in den abhämgigen Ansprüchen beschrieben.

Die Figuren 1 bis 3 zeigen unterschiedliche Ausführungsbeispiele des erfindungsgemäßen Spulenkerns.

In den Figuren 4 und 5 sind zwei Ansichten eines Drehzahlgebers dargestellt, für den der erfindungsgemäße Spulenkern Verwendung finden kann.

Die Figuren 6 und 7 lassen schematisch die Wirkungsweise des erfindungsgemäßen Spulenkerns erkennen, während Figur 8 eine an einem Beispiel gemessene Hystereseschleife und Figur 9 den bei diesem Beispiel gemessenen Impuls zeigen.

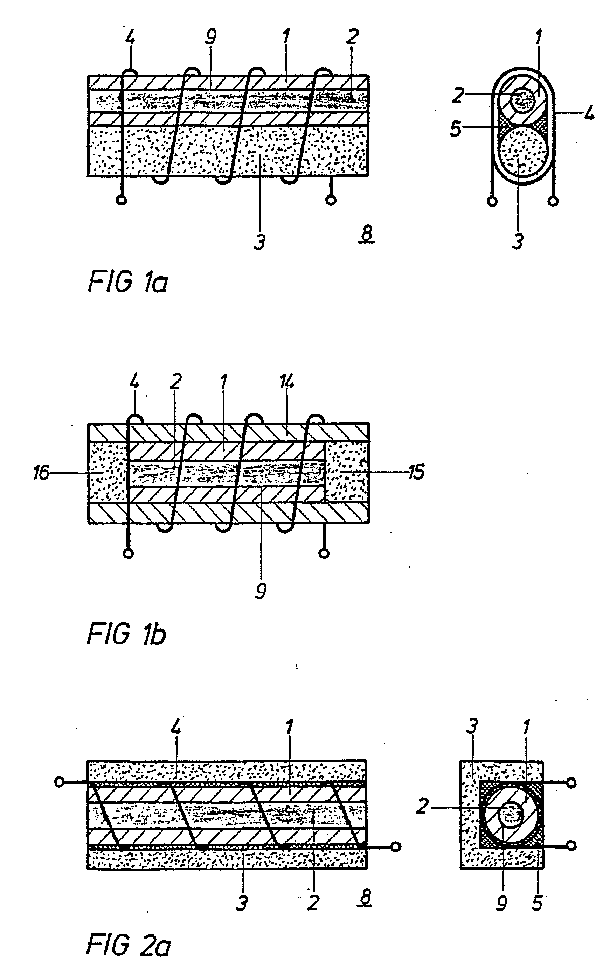

In Figur 1a enthält der Spulenkern 8 einen drahtförmigen Verbundkörper 9. Der Verbundkörper 9 besteht seinerseits aus einem Mantel 1 und einem Kern 2. Der Mantel 1 ist beispielsweise aus der Legierung 29Ni-17Co-Fe (mit 29 Gew.-% Nikkel, 17 Gew.-% Kobalt und Rest Eisen) gefertigt.

Das Material des Kerns 2 enthält z.B. 50 Gew.-% Kobalt, 2 Gew.-% Vanadium und Rest Eisen. Damit besteht sowohl der Mantel 1 als auch der Kern 2 jeweils aus einer Legierung mit üblicherweise weichmagnetischen Eigenschaften. Die Legierungen des Verbundkörpers 9 haben verschiedene thermische Ausdehnungskoeffizienten, so daß nach einer Glühbehandlung des fertig gezogenen Verbundkörpers 9 sich durch das anschließende Abkühlen Mantel 1 und Kern 2 gegeneinander verspannen und deswegen in Achsrichtung des Verbund-Körpers eine magnetische Vorzugsrichtung aufweisen. Parallel zu dem Verbundkörper 9 ist nun ein ebenfalls zylindrisch ausgebildeter Dauermagnet 3 angeordnet und durch Gießharz 5 fest mit dem Verbundkörper 9 verbunden. Um den Spulenkern 8 ist eine Spule 4 herumgewickelt, in der bei Ummagnetisierung des Verbundkörpers 9 (Bern und/oder Mantel 1) eine Spannung erzeugt wird. In Figur 1b ist der Verbundkörper 9 mit zwei achsial daran angrenzenden Dauermagneten 15 und 16 in einem unmagnetischen Hüllrohr 14 gehalten, das die Spule 4 trägt.

In Figur 2a sind gleiche Teile mit gleichen Bezugszeichen versehen. Der Dauermagnet 3 ist im Gegensatz zu Figur 1a nicht zylindrisch, sondern weist einen U-förmigen Querschnitt auf und der Verbundkörper 9 ist zusammen mit der Spule 4 zwischen die Schenkel des U-förmigen Dauermagneten 3 eingelegt und dort mit Hilfe von Gießharz 5 vergossen.

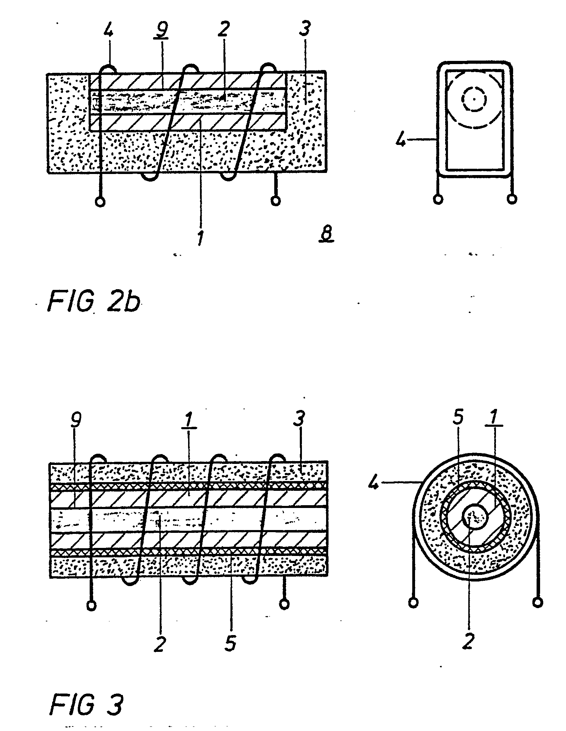

Ähnlich ist die Anordnung in Figur 2b. Sie weist ebenfalls eine andere Form des Dauermagneten 3 auf. Dieser ist hier länger als der Verbundkörper, so daß der Verbundkörper 9 in Längsrichtung in einem Einschnitt im Dauermagneten 3 befestigt ist. Hier ist die Spule 4 um Verbundkörper und Dauermagnet gewickelt. In Figur 3 umgibt der Dauermagnet 3 den Verbundkörper 9 kreisförmig, was bei relativ großem elektrischem Widerstand des Dauermagneten zulässig sein kann.

Die Figuren 4 und 5 zeigen ein Anwendungsbeispiel des Spulenkerns mit der Spule 4 als Sensor für die Stellung einer Scheibe 6. Die Scheibe 6 ist zur Erzeugung eines Magnetfeldes mit einem Dauermagneten 7 an einer Umfangsstelle versehen. Dieser bewirkt beim Vorbeibewegen in dem Spulen-Kern 8 eine Ummagnetisierung desselben, so daß ein Spannungsimpuls in der Spule 4 erzeugt wird.

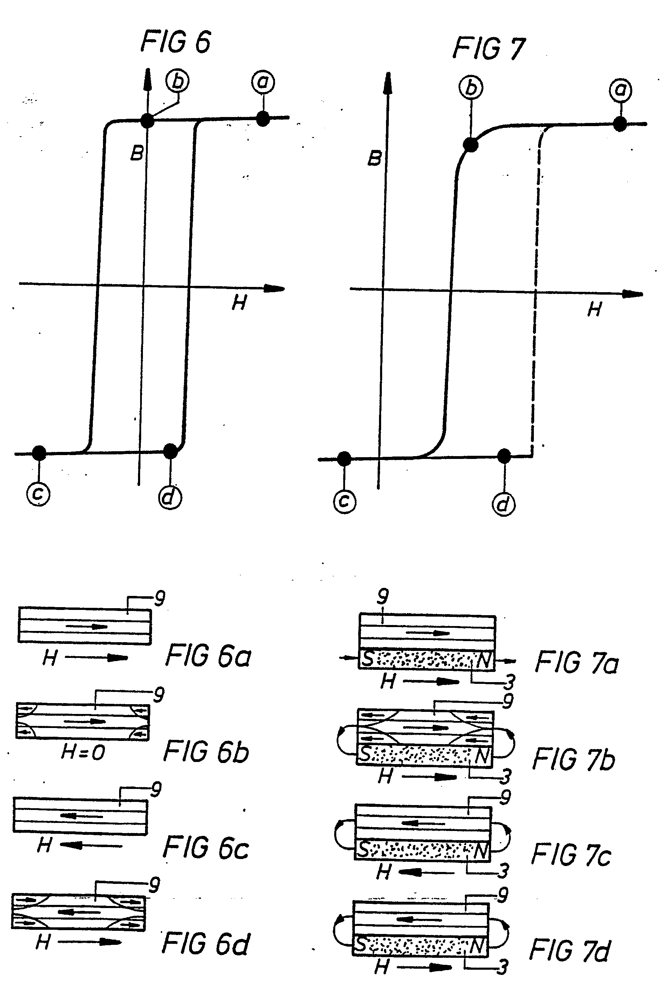

Figur 6 zeigt die Hystereseschleife (Induktion B in Abhängigkeit von der Feldstärke H) eines Verbundkörpers aus gegeneinander verspannten Materialien, von denen eines weichmagnetisch anisotrop ist. Der Verbundkörper 9 ist dabei etwa gleich lang wie die Abmessungen der den Spulenkern umgebenden Spule. Auf der Hystereseschleife sind vier Punkte a bis d markiert; die zugehörige Feldstärke bzw. Magnetisierungsrichtung des Verbundkörpers ist aus den entsprechend bezeichneten Figuren 6 a bis 6 d zu ersehen. Bei hoher Feldstärke im Punkt a ist der Verbund-Körper in Richtung der Feldstärke magnetisiert. Vermindert man die Feldstärke auf den Wert Null - entsprechend Punkt b - dann bleibt die Magnetisierungsrichtung im wesentlichen erhalten, allerdings tritt an den Stirnseiten und besonders an den Ecken der Stirnseiten eine Ent- bzw. Ummagnetisierung durch das Eigenfeld ein. Beim Durchlaufen der Schleife von Punkt b bis Punkt c wird der Verbundkörper ummagnetisiert bis - wie Figur 6 c zeigt - Magnetisierungsrichtung und Feldstärke wieder übereinstimmen. Figur 6 d läßt erkennen, daß bei Umkehrung der Feldstärke zunächst die Magnetisierungsrichtung im wesentlichen erhalten bleibt, bis dann wiederum eine Ummagnetisierung erfolgt und der in Figur 6 a dargestellte Zustand wieder erreicht ist.

Während man bei relativ langen magnetischen Drähten, wie von Franz Preisach schon 1932 beschrieben, eine plötzliche Ummagnetisierung bei Erreichen bestimmter Feldstärkewerte erzielen kann, ist dies bei kurzen Drähten wegen der Randeffekte nicht möglich. Trotz der relativ guten Rechteckform der Hystereseschleife in Figur 6 wird daher die in der Spule 4 erzeugte Spannung im wesentlichen proportional zur Ummagnetisierungsfrequenz sein.

Diese Situation ändert sich, wenn man erfindungsgemäß parallel zum Verbundkörper einen Dauermagneten anordnet. In diesem Fall verschiebt sich die Hysteresekurve wie in Figur 7 dargestellt. Wiederum sind auf dieser Hysteresekurve vier Punkte a bis d eingetragen, deren entsprechende Magnetisierungszustände in den Figuren 7 a bis d dargestellt sind. In Figur 7 a und in Figur 7 c sind Magnetisierungsrichtung im Verbundkörper und angelegte Feldstärke gleichgerichtet. Beim Übergang von Punkt a nach Punkt b - also bei einer Verminderung der Feldstärke - versucht der Dauermagnet 3 das im Verbundkörper vorhandene weichmagnetische Material umzumagnetisieren, so daß die ent- bzw. ummagnetisierten Bereiche in Figur 7 b bereits weiter ausgebildet sind, als dies in Figur 6 b der Fall ist. Der Verbundkörper 9 wird dann bei weiter abnehmender Feldstärke ummagnetisiert, bis er in der anderen Richtung gesättigt ist (Figur 7 c).

Bei erneuter Umkehr der Magnetisierungsrichtung, wie in Figur 7 d dargestellt, ist die Magnetisierungsrichtung im Verbundkörper wieder entgegengesetzt zur Feldstärke H. Trotzdem bilden sich keine Ent- bzw. Ummagnetisierungsbereiche, da das Magnetfeld des Dauermagneten 3 versucht, die Magnetisierungsrichtung im Verbundkörper bestehen zu lassen.

Damit entstehen die gleichen Verhältnisse wie in der eingangs genannten Veröffentlichung von Franz Freisach beschrieben, nur mit dem Unterschied, daß nicht ein sehr langer aufmagnetisierter Draht, sondern der dem Verbund-Körper beigegebene Dauermagnet das Auftreten der Randerscheinungen verhindert. Bei weiter ansteigender Feldstärke erfolgt dann eine plötzliche Ummagnetisierung, bis der in Figur 7 a dargestellte Zustand wieder erreicht ist. Diese Ummagnetisierung ist frequenzunabhängig. Die Schleife wird in diesem Teil immer schnell durchlaufen, wie durch die gestrichelte Linie in Figur 7 angedeutet ist.

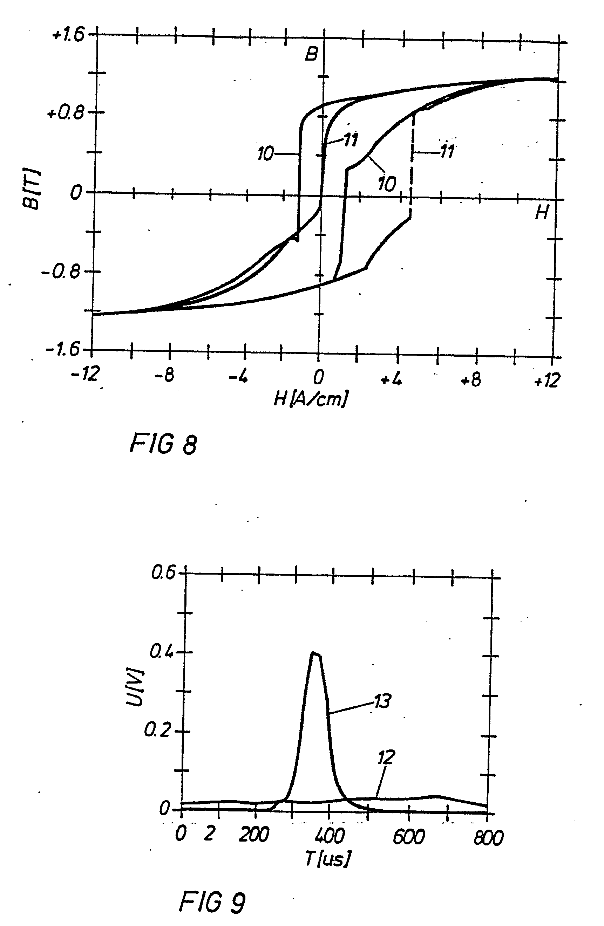

In Figur 8 sind wiederum zwei Hystereseschleifen dargestellt, die an dem eingangs beispielhaft erwähnten Verbundkörper gemessen worden sind. Dabei gilt die mit 10 bezeichnete Kurve in Figur 8 für den Verbundkörper allein, während die Kurve 11 die Verhältnisse zeigt, wenn neben den Verbundkörper aus dem eingangs erwähnten Beispiel ein gleich langer aufmagnetisierter hartmagnetischer Draht gelegt wird. Man sieht, daß sich die Hystereseschleife horizontal in Richtung der H-Achse, entsprechend der Wirkung des Dauermagneten, verschiebt und daß jetzt bei ansteigender positiver Feldstärke von etwa 4 A/cm eine plötzliche Ummagnetisierung erfolgt.

Die Kurve 12 in Figur 9 zeigt dabei die Spannung U über der Zeit T, wenn die Kurve 10 in Figur 8 langsam durchlaufen wird. Die Kurve 13 läßt den Spannungsverlauf erkennen, wenn neben den Verbundkörper ein aufmagnetisierter Dauermagnet, entsprechend Kurve 11 in Figur 8, angeordnet ist.

Aus Kurve 11 in Figur 8 läßt sich außerdem erkennen, daß unterschiedlich starke Dauermagnete in Verbindung mit einem Verbundkörper geeignet sind, um unterschiedliche Sprungfeldstärken einstellen zu können. Da das Dauermagnetmaterial nicht mehr verformbar sein muß, können Materialien mit sehr hohen Koerzitivfeldstärken verwendet werden, so daß man mit Kleineren Dauermagneten und mit kurzen Verbundkörpern sicher reproduzierbare Ergebnisse erhält. Da außerdem die Koerzitivkraft des Dauermagneten diejenige des weichmagnetischen Materials um mehrere Größenordnungen übertrifft, ist es nicht mehr erforderlich, einen bestimmten engen Bereich für die symmetrische oder unsymmetrische Änderung der Feldstärke vorzuschreiben. In der Konstruktion von Stellungssensoren ist man deshalb weitgehend frei und Kann bei gleichem Verbundkörper unterschiedlich definierte Ansprechfeldstärken verwirklichen.

Als Beispiel für die Herstellung eines Verbundkörpers aus zwei gegeneinander verspannten Materialien wurde in ein Rohr aus der Legierung 29Ni-17Co-Fe mit den Abmessungen 64 x 17 mm (d.h. 64mm Außendurchmesser, 17 mm Wandstärke) und ca. 1000 mm Länge ein Rundstab aus der Legierung 49Co-2V-Fe mit den Abmessungen 30 mm Durchmesser und ca. 950mm Länge eingepaßt. Die Rohrenden wurden mit Verschlußstücken aus dem Rohrmaterial vakuumdicht zugeschweißt.

Über ein Abpumprohr mit ca. 10 mm Innendurchmesser, das an einem der Verschlußstücke angebracht war, wurde der Innenraum evakuiert. Der Verbundkörper wurde bei Temperaturen von 1250° C und 1000° C auf eine Abmessung von 7,5 mm heißgewalzt. Nach Säuberung und Abtrennen der Enden wurde das Material auf einen Durchmesser Vom 0,20 mm mit einer Zwischenglühung kaltgezogen. Die abschließende Glühbehandlung erfolgte 1 Stunde bei 750° C.

Ein derartig hergestellter Verbundkörper wurde auf eine Länge von 30 mm gekürzt und einmal allein und einmal zusammen mit einem gleich langen hartmagnetischen Draht für die Messung der in Figur 8 dargestellten Kurve verwendet.

## Ansprüche

1. Spulenkern (8) für eine induktive, frequenzunabhängige Schaltvorrichtung der einen draht- oder stabförmigen Verbundkörper (9) aufweist, der aus mindestens zwei gegeneinander in Richtung der Längsachse des Verbundkörpers (9) mechanisch verspannten Materialien besteht, von denen mindestens eines ferromagnetisch ist und in Richtung der Längsachse anisotrope, weichmagnetische Eigenschaften besitzt,
**dadurch gekennzeichnet,**
daß parallel zur und/oder in Richtung der Längsachse des Verbundkörpers (9) an diesem mindestens ein in Richtung dieser Längsachse magnetisierter Dauermagnet (3) befestigt ist.

2. Spulenkern nach Anspruch 1,
**dadurch gekennzeichnet,**
daß die Form und/oder relative Lage des Dauermagneten (3) im Verhältnis zum Verbundkörper (9) so gewählt sind, daß an jeder Stelle des Verbundkörpers (9) die in Längsrichtung des Verbundkörpers (9) gerichteten Komponenten aller den Verbundkörper (9) durchdringenden Feldlinien des Dauermagneten (3) untereinander die gleiche Richtung aufweisen.

3. Spulenkern nach Anspruch 1,
**dadurch gekennzeichnet,**
daß der Dauermagnet (3) die gleiche Länge wie der Verbundkörper (9) aufweist und mit seiner Längsachse parallel zum Verbundkörper an diesem befestigt ist

4. Spulenkern nach Anspruch 3,
**dadurch gekennzeichnet,**
daß der Verbundkörper (9)unmittelbar von einer Spule (4) umgeben ist.

5. Spulenkern nach Anspruch 3,
**dadurch gekennzeichnet,**
daß der Dauermagnet (3) einen U-förmigen Querschnitt aufweist und daß der Verbundkörper (9) zwischen den U-förmigen Schenkeln des Dauermagneten (3) angeordnet ist.

6. Spulenkern nach Anspruch 1,
**dadurch gekennzeichnet,**

daß der Dauermagnet (3) gegenüber dem Verbundkörper (9) eine größere Länge besitzt und das der Verbundkörper(9)in eine Öffnung bzw. in einen Einschnitt des Dauermagneten (3) eingelegt und dort befestigt ist.

7. Spulenkern nach Anspruch 1,
**dadurch gekennzeichnet,**
daß der Verbundkörper (9) zusammen mit Dauermagnetscheiben (15,16) an seinen Stirnseiten in einem isolierenden unmagnetischen Hüllrohr (14) gehalten ist.

8. Spulenkern nach den Ansprüchen 1 bis 7,
**dadurch gekennzeichnet,**
daß ein pulvermetallurgisch hergestellter Dauermagnet (3) hoher Koerzitivfeldstärke zusammen mit dem Verbundkörper (9) den Spulenkern (8) bildet.

## Claims

1. A coil core (8) for an inductive, frequency-independent switching device comprises a wire-like or rod-like compound body (9) which is composed of at least two materials which are mechanically braced in relation to one another in the direction of the longitudinal axis of the compound body (9) and of which at least one is ferromagnetic and possesses soft-magnetic properties, anisotropic in the direction of the longitudinal axis, characterised in that in parallel to and/or in the direction of the longitudinal axis of the compound body (9) at least one permanent magnet (3) magnetised in the direction of this longitudinal axis is attached to the compound body (9).

2. A coil core as claimed in claim 1, characterised in that the shape and/or position of the permanent magnet (3) relative to the compound body (9) are selected to be such that at each position of the compound body (9) the components, directed in the longitudinal direction of the compound body (9), of all the field lines of the permanent magnet (3) which penetrate through the compound body (9) face in the same direction as one another.

3. A coil core as claimed in claim 1, characterized in that the permanent magnet (3) has the same length as the compound body (9) and is attached to the compound body with its longitudinal axis parallel thereto.

4. A coil core as claimed in claim 3, characterized in that the compound body (9) is directly surrounded by a coil (4).

5. A coil core as claimed in claim 3, characterised in that the permanent magnet (3) has a U-shaped cross-section and that the compound body (9) is arranged between the U-shaped flanks of the permanent magnet (3).

6. A coil core as claimed in claim 1, characterized in that the permanent magnet (3) has a longer length than the compound body (9) and that the compound body (9) is inserted into an opening or an indentation in the permanent magnet (3) and is attached thereto.

7. A coil core as claimed in claim 1, characterised in that the compound body (9), together with permanent magnet discs (15,16), is supported at its ends in an insulating, non-magnetic jacket tube (14).

8. A coil core as claimed in claims 1 to 7, characterised in that a permanent magnet (3) of high coercive force and produced by powder metallurgy forms the coil core (8) together with the compound body (9).

## Revendications

1. Noyau de bobine (8) pour un dispositif inductif de commutation, indépendant de la fréquence, qui présente un corps composite (9) en forme de fil ou de barre, qui se compose d'au moins deux matériaux serrés mécaniquement l'un contre l'autre dans la direction de l'axe longitudinal du corps composite (9), dont au moins l'un est ferromagnétique et présente en direction de l'axe longitudinal des propriétés de faible coercitivité anisotropes, caractérisé en ce qu'au moins un aimant permanent (3) est fixé parallèlement à et/ou en direction de l'axe longitudinal du corps composite (9), sur celui-ci, aimant magnétisé en direction de cet axe longitudinal.

2. Noyau de bobine selon la revendication 1, caractérisé en ce que la forme et/ou la position relative de l'aimant permanent (3), par rapport au corps composite (9), sont choisies telles qu'en tout endroit du corps composite (9), les composantes, orientées en direction longitudinale du corps composite (9), de toutes les lignes de champ de l'aimant permanent (3) traversant le corps composite (9) présentent entre elles la même direction.

3. Noyau de bobine selon la revendication 1, caractérisé en ce que l'aimant permanent (1) présente la même longueur que le corps composite (9) et est fixé sur le corps composite avec son axe longitudinal parallèle à celui-ci.

4. Noyau de bobine selon la revendication 3, caractérisé en ce que le corps composite (9) est directement entouré par une bobine (4).

5. Noyau de bobine selon la revendication 1, caractérisé en ce que l'aimant permanent (3) présente une section transversale en forme de U et que le corps composite (9) est disposé entre les branches en forme de U de l'aimant permanent (3).

6. Noyau de bobine selon la revendication 1, caractérisé en ce que l'aimant permanent (3) présente une longueur supérieure à celle du corps composite (9) et que le corps composite (9) est inséré et fixé dans une ouverture, ou dans une entaille de l'aimant permanent (3).

7. Noyau de bobine selon la revendication 1, caractérisé en ce que le corps composite (9), conjointement avec des disques d'aimant permanent (15, 16) placés sur ses faces frontales, est maintenu dans un tube d'enveloppe (14) isolant amagnétique.

8. Noyau de bobine selon la revendication 1, caractérisé en ce que le noyau (8) de la bobine est formé, conjointement avec le corps composite (9), par un aimant permanent (3) constitué métallurgiquement d'une poudre et présentant une intensité élevée de champ coercitif.

FIG 1a

FIG 1b

FIG 2a

FIG 2b

FIG 3

FIG 4

FIG 5

FIG 6

FIG 7

FIG 6a

FIG 6b

FIG 6c

FIG 6d

FIG 7a

FIG 7b

FIG 7c

FIG 7d

FIG 8

FIG 9